# EUROPEAN PATENT SPECIFICATION

(11) **EP 3 726 208 B1**
(45) Date of publication and mention of the grant of the patent: **27.05.2026**
(21) Application number: 20169982.4
(22) Date of filing: 16.04.2020
(51) Int. Cl.: G01N 27/30, G01N 27/407

(54) **HIGH SURFACE AREA ELECTRODE FOR ELECTROCHEMICAL SENSOR**
ELEKTRODE MIT GROSSER OBERFLÄCHE FÜR ELEKTROCHEMISCHEN SENSOR
ÉLECTRODE À SURFACE ÉLEVÉE POUR CAPTEUR ÉLECTROCHIMIQUE

(30) Priority: 18.04.2019 US 201916388584
(43) Date of publication of application: 21.10.2020
(73) Proprietor: Honeywell International Inc., Morris Plains, NJ 07950 (US)
(72) Inventor: BECK, Scott Edward, Morris Plains, NJ 07950 (US); FOSTER, Philip C., Morris Plains, NJ 07950 (US); WANG, Yong-Fa, Morris Plains, NJ 07950 (US)
(74) Representative: Haseltine Lake Kempner LLP

(56) References cited:
- US-A- 4 812 221
- US-A- 6 068 748
- US-A1- 2018 372 664
- US-A1- 2019 041 351
- VAN DER WAL P D ET AL: "Extremely stable Nafion based carbon monoxide sensor", SENSORS AND ACTUATORS B: CHEMICAL, ELSEVIER BV, NL, vol. 35, no. 1, 1 September 1996 (1996-09-01), pages 119 - 123, XP004049741, ISSN: 0925-4005, DOI: 10.1016/S0925-4005(97)80040-8
- VASEEM MOHAMMAD ET AL: "Inkjet Printed Fractal-Connected Electrodes with Silver Nanoparticle Ink", APPLIED MATERIALS & INTERFACES, vol. 4, no. 6, 15 June 2012 (2012-06-15), US, pages 3300 - 3307, XP055945543, ISSN: 1944-8244, DOI: 10.1021/am300689d
- SCHALDACH M.: "Fractal Coated Leads: Advanced Surface Technology for Genuine Sensing and Pacing", PROGRESS IN BIOMEDICAL RESEARCH, 1 June 2000 (2000-06-01), pages 259 - 272, XP055945561, Retrieved from the Internet <URL:https://www.msbt.nat.fau.de/PBMR/documents/200005040259.pdf> [retrieved on 20220722]
- WENDONG YANG: "Metal particle-free inks for printed flexible electronics", JOURNAL OF MATERIALS CHEMISTRY C, vol. 7, no. 48, 1 January 2019 (2019-01-01), GB, pages 15098 - 15117, XP093164711, ISSN: 2050-7526, DOI: 10.1039/C9TC05463D

## Description

### TECHNICAL FIELD

The present disclosure relates generally to electrochemical sensors. In particular, various embodiments of electrochemical sensors are described having a high-surface area electrode.

### BACKGROUND

Electrochemical sensors are devices that interact with selected chemical species and transduce the chemical energy of the interaction into a signal that can be detected and analyzed to provide information of the selected chemical species. For example, electrochemical gas sensors can measure the concentration of a target gas by oxidizing or reducing the target gas at an electrode and measuring the resulting current. Sensors of this type often contain one or more electrodes in contact with an electrolyte. When gas interacts with an electrode, the electrochemical reaction may result in an electric current that passes through an external circuit for intensity measurement.

Electrochemical sensors may be employed, as an example, for environmental monitoring. For example, the sensors may monitor air quality, detect the presence of air pollution, and/or determine the composition of sources of air pollution. Electrochemical sensors may also be employed for personal safety in settings where dangerous chemicals may suddenly exist. The sensors may trigger audible alarms and/or visible warning lights. Some electrochemical sensors require no system power to operate (i.e. requiring no bias voltage across electrodes of the sensors), and are thus well-suited for high-volume commercial battery-powered applications.

More recently, MEMS electrochemical sensors have been developed. However, because electrochemical sensors of this type are smaller, the current produced by the reaction of the analyte (e.g., the chemical species of interest) is also smaller. In particular, MEMS electrochemical sensors typically include planar electrodes on the order of less than 50 square mm and produce current in the nA range. The inventors have recognized that this impacts the ability of MEMS electrochemical sensors to reliably measure and distinguish a large range of chemical concentrations. Accordingly, there is a need in the art for MEMS electrochemical sensors with improved sensing ability and corresponding methods for manufacturing the same.

P. D. van der Wal et al. "Extremely stable Nafion based carbon monoxide sensor," Sensors and Actuators B 35-36 (1996) 119-123, discloses a dry Nafion coated 3-electrode cell with thin film platinum electrodes on a silicon nitride insulating layer. On the working electrode, platinum black is electrodeposited.

US 6,068,748 A discloses a planar, solid-state electrochemical oxygen sensor having a substrate, conductive strips deposited on the substrate, and a dielectric layer insulating portions of the conductive strips except those portions which define a working electrode and at least one second electrode. The working electrode may be defined by an open printed region of the dielectric, or by a needle-punched or laser-burned hole or opening in the dielectric which exposes a small region of one of the conduct strips.

US 2018/372664 A1 discloses methods of fabricating devices via selective laser etching. The methods are used to fabricate capacitive humidity sensors with intricate electrodes, e.g. having a fractal pattern.

US 4,812,221 A discloses a sensor for gaseous and vaporous species. The sensor comprises a substrate having a surface having an opening therein. A gas and vapor permeable sensing electrode having front and back sides is located across the opening with the front side facing generally the same direction as does the surface. A gas flow path leads to the back side of the sensing electrode. An electrolytic medium is in contact with the front side of the electrode. An additional electrode is in contact with the electrolytic medium and is electronically isolated from the sensing electrode other than via the electrolytic medium.

US 2019/041351 A1 discloses an electrochemical sensor comprising a substrate disposed within a housing, a plurality of electrodes disposed on a first surface of the substrate, an electrolyte disposed over at least a portion of each electrode of the plurality of electrodes, and a capillary disposed through the substrate. The capillary is configured to provide a diffusion pathway for a target gas to pass from an exterior of the housing to one or more of the plurality of electrodes.

### BRIEF SUMMARY

The present invention is set out in the appended claims.

### BRIEF DESCRIPTION OF THE DRAWINGS

FIG. 1 depicts a cross-sectional elevation view of an exemplary MEMS-based electrochemical sensor according to an embodiment of the present invention.
FIG. 2 illustrates a first step of a method of fabricating a MEMS-based electrochemical sensor in which an oxidized substrate is provided according to one embodiment.
FIG. 3 illustrates a second step of a method of fabricating a MEMS-based electrochemical sensor in which a plurality of electrodes are deposited according to one embodiment.
FIG. 4 illustrates a third step of a method of fabricating a MEMS-based electrochemical sensor in which a dielectric layer is coated and patterned according to one embodiment.
FIG. 5 illustrates a fourth step of a method of fabricating a MEMS-based electrochemical sensor in which a high surface area electrode is deposited and defined according to one embodiment.
FIG. 6 illustrates a fifth step of a method of fabricating a MEMS-based electrochemical sensor in which an electrolyte is disposed according to one embodiment.
FIG. 7 depicts a cross-sectional elevation view of another exemplary MEMS-based electrochemical sensor according to an embodiment of the present invention.
FIG. 8 illustrates a MEMS-based electrochemical sensor on a circuit board according to an embodiment of the present invention.

### DETAILED DESCRIPTION OF ILLUSTRATIVE EMBODIMENTS

Various embodiments of MEMS-based electrochemical sensors are described herein. According to various embodiments, a high surface area electrode is provided and disposed on top of a sensing electrode of the MEMS-based electrochemical sensor. As detailed herein, the high surface area electrode has the advantage of increasing a current or potential produced by the MEMS-based electrochemical sensor in response to one or more targeted chemical species or gases. Furthermore, the use of the high surface area electrode allows fabrication and operation of smaller electrochemical sensors. The smaller size of the MEMS-based electrochemical sensor described herein also reduces the packaged power requirements.

For these reasons, the MEMS-based electrochemical sensor may have a low-cost and small footprint. As a result, the electrochemical sensors described herein can be more effectively integrated with a mobile device or Internet of Things (IoT) apparatus to detect one or more chemical species. Indeed, the various technical advantages of the high surface area electrode enable a wide range of applications for the MEMS-based electrochemical sensor, including environmental monitoring, air quality monitoring, and personal protection, among others

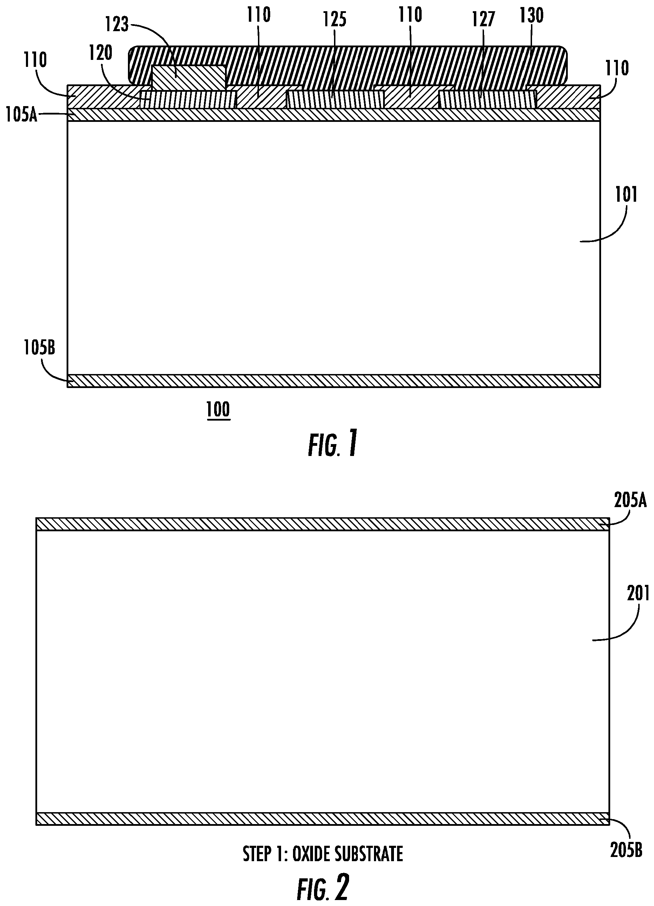

FIG. 1 depicts a cross-sectional elevation view of an exemplary MEMS-based electrochemical sensor 100 according to one embodiment. In the illustrated embodiment, the sensor 100 comprises a substrate 101 having a plurality of electrodes. The plurality of electrodes include a sensing electrode 120, a counter electrode 125, and a reference electrode 127. The electrodes 120, 125, 127 are disposed on a first insulator layer 105A formed on a top surface of the substrate 101. A second insulator layer 105B may be disposed on the opposite side of the substrate 101. Additionally, as described in greater detail herein, a high surface area electrode 123 is formed on an upper surface of the sensing electrode 120.

The electrochemical sensor 100 further comprises an electrolyte 130, which is disposed over at least a portion of each electrode 123, 125, 127. A dielectric layer 110 is also provided and formed over at least a portion of the top surface of the first insulator layer 105A (e.g., the portion of the first insulator layer 105A that is not covered by the plurality of electrodes). In some embodiments, the dielectric layer 110 may also cover a portion of each of the electrodes 120, 125, 127.

According to various embodiments, the substrate 101 may be formed from silicon, which is very well-characterized and for which equipment and processes are well-established. In some implementations, the substrate may comprise silicon nitride, silicon oxide, a doped silicon (e.g. doped with boron, arsenic, phosphorous, or antimony) or any combination thereof.

In various other embodiments, the substrate 101 may comprise semiconductors, plastics, or ceramics. For example, the substrate may be a porous alumina (Al₂O₃) substrate, a porous silica (SiO₂) substrate, a porous silicon substrate, a silicon substrate with micro-channels, or a polytetrafluoroethylene (PTFE) substrate.

According to various embodiments, the first insulator layer 105A is grown on top of the substrate 101. The insulator layer may be, for example, an oxide layer. In some alternative embodiments, the first insulator layer 105A may be a polymeric or glass insulator layer printed on top of the substrate 101. In various embodiments, the insulator layers 105A and 105B may be deposited by any suitable method (e.g., chemical vapor deposition, sputtering, and the like).

The second insulator layer 105B can be formed using the same method as that of the first insulator layer 105A. In other embodiments, the MEMS-based electrochemical sensor 100 may be formed on a ceramic or other insulating substrate. The sensor 100 can be disposed directly on the insulating substrate without the insulator layers 105A and 105B.

In some embodiments, the plurality of electrodes 120, 125, 127 are deposited on top of the first insulator layer 105A. The sensing electrode 120, the counter electrode 125, and the reference electrode 127 can be arranged in a co-planar, non-overlapping arrangement on the surface of the first insulator layer 105A. While the MEMS-based electrochemical sensor shown in FIG. 1 includes three electrodes, various other embodiments of the MEMS-based electrochemical sensor 100 can also be used with only two electrodes (e.g., the sensing electrode 120 and the counter electrode 125).

In certain embodiments, the electrochemical sensor 100 includes a sensing electrode 120 and counter electrode 125. In such embodiments, the reference electrode 127 may be excluded from the sensor 100.

In other embodiments, four or more electrodes may be present. For example, two or more sensing electrodes may be present to enable the detection of more than one target chemical species or gases. Additionally, four or more electrodes may be present to enable diagnostic tests to be conducted during operation of the MEMS-based electrochemical sensor 100, continuously, periodically, or aperiodically. For some other implementations, bond pads and pads for the electrical connections for the electrochemical depositions of the platinum group metals and gold may be present. In some contexts, the sensing electrode 120 may also be referred to as a working electrode.

When semiconductor manufacturing techniques are used to form the MEMS-based sensor 100, the electrodes 120, 125, 127 may comprise materials capable of being deposited by such processes as thermal deposition, sputtering, chemical vapor deposition, electrodeposition, or the like. For example, the electrodes 120, 125, 127 may comprise materials capable of being electrodeposited and etched to form the individual electrodes.

In some embodiments, the sensing electrode 120, the counter electrode 125, and the reference electrode 127, are printed on top of the first insulator layer 105A. For example, in embodiments where printing technologies are used to manufacture the MEMS-based electrochemical sensor 100, the electrodes 120, 125, 127 can be printed using conductive inks. The conductive inks can be particle-free metal complex inks. Alternatively, the conductive inks may contain metal nanoparticles, such as gold or silver nanoparticles for example, dispensed in liquid solvent. Substrate heating may be necessary after deposition to evaporate the liquid so that only the solid conductive material remains. Sintering at an elevated temperature for an extended duration may be necessary to improve the conductivity of the printed electrodes.

The composition, size, and configuration of the electrodes 120, 125, 127 can depend on the specific species of targeted chemicals or gases being detected by the MEMS-based electrochemical sensor 100. In some examples, the size of each of the plurality of electrodes can be on the order less than 50 square mm.

The electrodes 120, 125, 127 generally allow for various reactions to take place to allow a current or potential to develop in response to the presence of one or more targeted chemical species or gases. The resulting signal may then allow for the concentration of the targeted chemical species or gases and/or other information, such as whether a targeted chemical species or gas exists, to be determined. The electrodes can comprise a reactive material suitable for carrying out a desired reaction. For example, the sensing electrode 120 and/or the counter electrode 125 can be formed of one or more metals or metal oxides such as copper, silver, gold, nickel, platinum, palladium, rhodium, ruthenium, combinations thereof, alloys thereof, and/or oxides thereof. The reference electrode 127 can comprise any of the materials listed for the sensing electrode 120 and/or the counter electrode 125, though the reference electrode 127 may generally be inert to the materials in the electrolyte in order to provide a reference potential for the sensor. For example, the reference can contain a noble metal such as platinum or gold.

The dielectric layer 110 is formed over at least a portion of the top surface of the first insulator layer 105A that is not covered by the plurality of electrodes. For example, the dielectric layer 110 may be formed between the electrodes 120, 125, 127. The dielectric layer 110 also covers a portion of each of the electrodes 120, 125, 127. Common dielectric materials such as silicon oxide, silicon nitride, or a combination thereof may be employed. In some alternative embodiments, the dielectric layer 110 may be polymeric insulator printed on top of the first insulator layer 105A.

According to the invention, the high surface area electrode 123 is formed on top of the sensing electrode 120 to increase the current or potential produced by the MEMS-based electrochemical sensor 100 in response to the presence of one or more targeted chemical species or gases. The high surface area electrode 123 comprises fractal metal electrodes. For example, the high surface area electrode 123 can comprise fractal gold electrodes, fractal platinum electrodes, or combination thereof. For some applications, platinum is preferred - due to its catalytic properties. In some embodiments, the fractal metal electrodes in the high surface area electrode 123 can be fabricated using electrochemical deposition of platinum or gold. In some alternative embodiments, the high surface area metal electrodes in the high surface area electrode 123 can be formed by printing technologies using specially-formulated inks in a solvent mixture. The solvent mixture can be a solution or suspension containing a metal pre-cursor. Printing of the solution can be followed by a conversion process to produce the high surface area electrode 123.

In other embodiments in which the high-surface area electrode 123 is formed from a material having a complex topology, the high-surface area electrode 123 may be provided with non-planar surfaces. For example, in one embodiment, the high-surface area electrode 123 may be provided with a plurality of outwardly extending pillars (e.g., having a surface generally resembling a stalagmite formation). In other embodiments, the high-surface area electrode 123 may be provided with a fern leaf structure. In various embodiments, the high-surface area electrode 123 formed with a complex topology is constructed with a generally porous material, such as those described herein.

In some implementations, the electrolyte 130 can be disposed over at least a portion of each electrode 125, 127 and the high surface area electrode 123. In some embodiments, the electrolyte 130 may be a solid polymer electrolyte. Solid polymer electrolytes may resist evaporation which may advantageously produce a long-life product. In some implementations, the electrolyte 130 may be in a liquid or gel form. In some examples, the electrolyte 130 can be formed via a variety of printing technologies, including but not limited to ink jet printing, aerosol jet printing, or screen printing. Alternatively, the electrolyte can be added with a drop dispenser. After the electrolyte 130 is formed, or before depending on the electrolyte, the substrate or wafer can undergo singulation and subsequently be introduced into final packaging. The packaging of the sensor depends largely on the final system needs and constraints. In some alternative examples, the electrolyte 130 can be added during the packaging process after the substrate wafer of the MEMS-based sensor 100 is singulated.

In the MEMS-based electrochemical sensor 100 as shown in FIG. 1, the electrode 123 increases the surface area where the chemical species or gas, the sensing electrode, and the electrolyte are all in contact, sometimes called the "triple point". As a result of the increased surface area which enhances electrochemical activity, the current or potential produced by the MEMS-based electrochemical sensor 100 in response to the targeted chemical species or gas is increased. This improved response allows fabrication and operation of smaller electrochemical sensors that are currently commercially unavailable.

According to various embodiments, the MEMS-based electrochemical sensor 100 may have dimensions (e.g., length and/or width and/or thickness) on the scale of 1 mm × 1 mm × 1 mm to 10 mm × 10 mm × 10 mm. Due to the small size of the MEMS-based electrochemical sensor 100, one or more sensors can be integrated with a mobile device or Internet of Things (IoT) apparatus to detect one or more chemical species, thereby enabling a wide range of applications.

As one example, the MEMS-based electrochemical sensor 100 may be integrated with a mobile device to measure air quality. For example, the mobile device user may decide to move indoors if the pollution level is found too high. In another illustrative example, a miner may carry his mobile device (e.g., cell phone, tablet, watch, laptop) into a mine. The mobile device may contain a MEMS-based electrochemical sensor that is designed to detect one or more relevant gases (e.g., oxygen, carbon monoxide, hydrogen sulfide). The mobile device may alert the miner when one or more of those gases cross a predetermined threshold. Accordingly, the MEMS-based electrochemical sensor 100 may protect the miner's health.

In aerospace applications, users may monitor, for example, oxygen levels on an airplane. In some examples, oxygen levels may also be monitored by individuals who are prescribed oxygen therapy, such as individuals with chronic obstructive pulmonary disease (COPD). In such examples, the individuals may need to be administered oxygen in situations where the oxygen levels decrease below a predetermined threshold.

In various home use embodiments, due to the small-size and low-cost of the MEMS-based electrochemical sensor 100, homeowners may purchase in-home electrochemical sensors economically. The economical aspect of the MEMS-based electrochemical sensor 100 may allow the homeowner to advantageously deploy the MEMS-based electrochemical sensors 100 in more places and/or may bring multiple gas sensing (e.g., CO, hydrogen sulfide (H₂S), nitrogen oxides (NOₓ), sulfur oxides (SOₓ), volatile organic compounds (VOCs)) within an average homeowner's budget.

FIGS. 2-6 show a method of fabricating a MEMS-based electrochemical sensor 100 according to an embodiment of the present invention. Figure 2 illustrates a first step in the exemplary fabrication method. In Step 1, oxide layers 205A and 205B are first formed on both sides of a substrate 201 to provide insulation for the substrate.

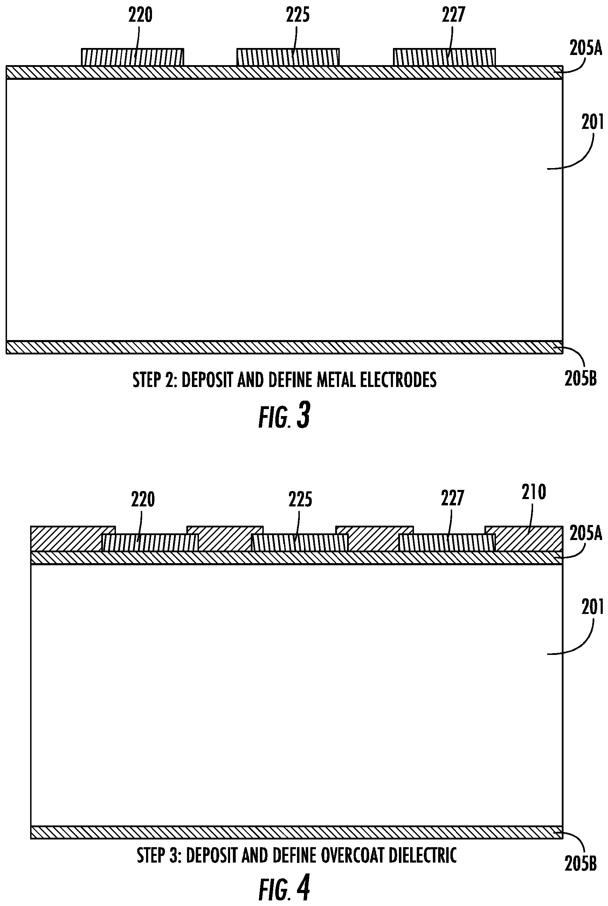

Figure 3 illustrates a second step in the exemplary fabrication method. In Step 2, a plurality of electrodes are disposed over the substrate. In particular, a sensing electrode 220, a counter electrode 225, and a reference electrode 227 are disposed on a top surface of the oxide layer 205A. This can be accomplished using suitable techniques, such as thermal deposition, sputtering, chemical vapor deposition, etching, electrodeposition, or the like.

Figure 4 illustrates a third step in the exemplary fabrication method. In Step 3, a dielectric layer 210 is coated over the top surface of the plurality of electrodes 220, 225, 227 and a portion of the top surface of the first insulator layer 205A that is not covered by the plurality of electrodes. The dielectric layer 210 is then patterned to expose at least a portion of the plurality of electrodes and possibly other areas (e.g., bond pads and pads for electrical connections). The dielectric material may be, for example, silicon oxide, silicon nitride, a polymer, or a combination thereof. The dielectric layer 210 may be deposited using plasma-enhanced chemical vapor deposition (PECVD) or spin coating, or spray coating, or jet printing, describing various processing methods for depositing and or patterning a thin dielectric film.

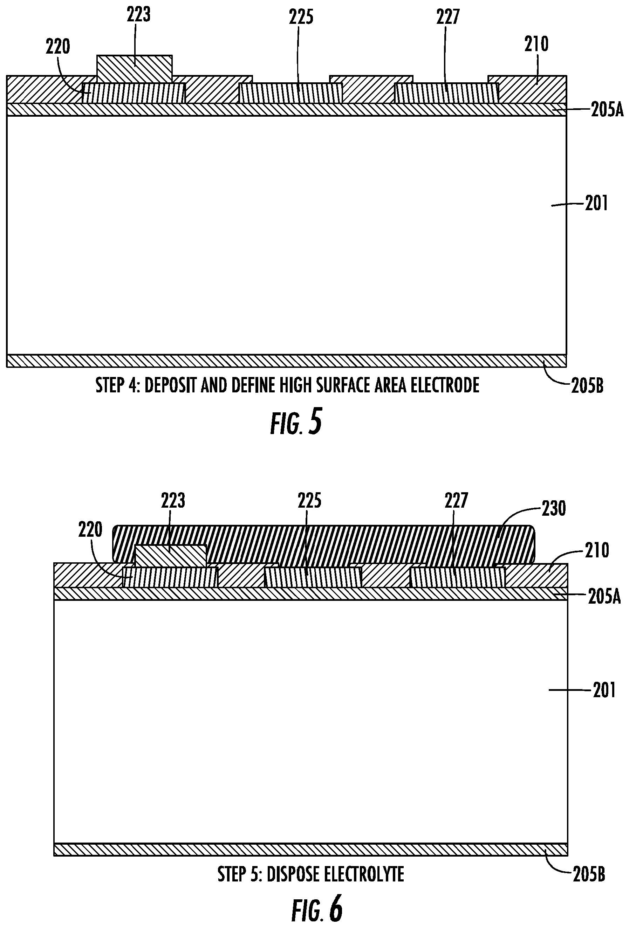

Figure 5 illustrates a fourth step in the exemplary fabrication method. In Step 4, the high surface area electrode 223 is deposited and defined. A photoresist layer is deposited over the dielectric layer 210 and the electrodes 225, 227. When the photoresist layer is deposited, it is patterned so as to leave the surface of the sensing electrode 220 exposed. The high surface area electrode 223 is then deposited on top of the sensing electrode 220. This step may be accomplished, for example, using an electrochemical deposition method (e.g., of platinum or gold). The high surface area electrode 223 may be formed from any of the suitable high surface area materials discussed herein.

Figure 6 illustrates a fifth step in the exemplary fabrication method. In Step 5, an electrolyte 230 is disposed over at least a portion of each electrode 225, 227 and the high surface area electrode 223. The electrolyte 230 can be a solid polymer electrolyte. The electrolyte 230 can be formed via a variety of printing technologies, such as ink jet printing, aerosol jet printing, or screen printing before singulation and subsequent packaging. Alternatively, the electrolyte 230 can be added during the packaging process after the substrate wafer of the MEMS-based electrochemical sensor is singulated.

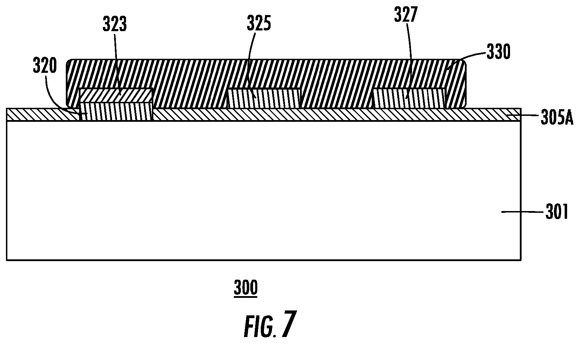

FIG. 7 depicts a cross-sectional elevation view of another exemplary MEMS-based electrochemical sensor 300 according to one embodiment. In the illustrated embodiment, the sensor 300 comprises a substrate 301 having a plurality of electrodes. The plurality of electrodes include a sensing electrode 320, a counter electrode 325, and a reference electrode 327. A first insulator/dielectric layer 305A is formed on a top surface of the substrate 301 such that at least a portion of electrodes 320, 325, 327 are not in contact with the substrate 301. Additionally, a high surface area electrode 323 is formed on an upper surface of the sensing electrode 320. The electrochemical sensor 300 further comprises an electrolyte 330, which is disposed over at least a portion of each electrode 323, 325, 327.

In some embodiments, the control circuitry and/or other processing circuitry (not shown in FIG. 1) for measuring the current or potential produced by the MEMS-based electrochemical sensor 100 may be formed on the same substrate of the MEMS sensor. Such a configuration may provide a more compact device and limit the potential for electrical noise to be introduced into the sensor output. In other embodiments, the MEMS-based electrochemical sensor 100 may be integrated with external circuitry designed for signal measurement or be directly integrated with existing circuitry within an instrument.

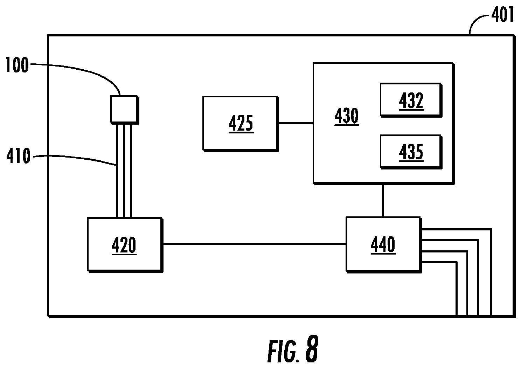

FIG. 8 illustrates the MEMS-based electrochemical sensor 100 in the context of exemplary circuitry 401. As will be appreciated from the description herein, the circuitry 401 may comprise an integrated circuit, printed circuit board, or the like. The circuitry 401 can be a separate component from the sensor, a portion of the packaging, or in some embodiments, an extension of the substrate such that the sensor 100 is formed on a single substrate that the other components are also disposed on. In this embodiment, the leads 410 may extend from pads electrically connected to the plurality of electrodes of the sensor 100 and contact various external circuitry such as a potentiostat circuitry 420, various sensing circuitry 425, operating and control circuitry 430, communication circuitry 440, and the like. The potentiostat circuitry 420 may control the voltage difference between the sensing electrode and the reference electrode of the sensor 100, and/or measure the current flow and/or voltage difference between the sensing electrode and the counter electrode of the sensor 100. The location of the potentiostat circuitry 420 at or near the sensor 100 may allow smaller currents to be detected while minimizing resistance, current loss, and electrical noise which would be inherent to longer electrical conductors. The various sensing circuitry 425 may comprise additional sensors, such as temperature and/or pressure sensors, which may allow for compensation of the outputs of the sensor 100 by taking compensation measurements at or near the sensor 100 itself. The operating and control circuitry 430 may comprise a processor 432 and a memory 435 for performing various calculations and control functions, which can be performed in software or hardware. The communication circuitry 440 may allow the overall sensor results or readings to be communicated to an external source, and can include both wired communications using for example contacts on the board, or wireless communications using a transceiver operating under a variety of communication protocols (e.g., WiFi, Bluetooth, etc.). In some embodiments, the sensor 100 can be a separate component that is electrically coupled to external operating circuitry.

It should be understood that the examples and embodiments described herein are for illustrative purposes only. Many modifications and other embodiments of the inventions set forth herein will come to mind to one skilled in the art to which these inventions pertain having the benefit of the teachings presented in the foregoing descriptions and the associated drawings. Therefore, it is to be understood that the inventions are not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A method of forming an electrochemical sensor, the method comprising:
disposing an insulator layer (205A) on a substrate (201);
forming a sensing electrode (220) either on the insulator layer (205A) or on the substrate (201);
forming a counter electrode (225) on the insulator layer (205A), such that the counter electrode (225) is not in contact with the substrate (201);
disposing a dielectric layer (210) over at least a portion of a top surface of the insulator layer (205A) and also over a portion of each of the sensing electrode (220) and the counter electrode (225);
disposing a photoresist layer on the dielectric layer (210) and also on the sensing electrode (220) and the counter electrode (225), wherein the photoresist layer comprises a pattern configured to expose at least a portion of the surface of the sensing electrode (220);
disposing a high surface area electrode (223) on the sensing electrode (220); and
disposing an electrolyte (230) on at least a portion of each of the high surface area electrode (223) and the counter electrode (225),
wherein the high surface area electrode (223) comprises a fractal metal electrode.

2. The method of claim **1,** wherein the high surface area electrode (223) comprises at least one of gold, platinum, palladium, rhodium, or ruthenium.

3. The method of claim **1,** wherein the substrate (201) comprises at least one of a porous silicon substrate, a porous alumina substrate, or a silicon substrate with micro-channels.

4. The method of claim **1,** wherein the sensing electrode (220) comprises at least one of metal or metal oxides such as copper, gold, nickel, platinum, palladium, rhodium or ruthenium.

5. The method of claim **1,** wherein the dielectric layer (210) comprises at least one of silicon oxide or silicon nitride.

6. The method of claim 1, wherein the high surface area electrode (223) is a porous platinum electrode.

7. The method of claim 1, wherein the high surface area electrode (223) comprises non-planar surfaces.

8. The method of claim 7, wherein the high surface area electrode (223) comprises a plurality of outwardly extending pillars.

9. The method of claim 7, wherein the high surface area electrode (223) comprises a fern-leaf structure.

10. The method of claim 1, wherein the electrolyte (230) comprises a solid polymer electrolyte.

11. The method of claim 1, further comprising performing singulation of the substrate (201).

12. The method of claim 1, wherein the sensing electrode (220) and the counter electrode (225) are formed using one of thermal deposition, sputtering, chemical vapor deposition, etching or electro-deposition.

13. The method of claim 1, wherein the electrolyte (230) is deposited using at least one of ink jet printing, aerosol jet printing or screen printing.

14. The method of claim 1, further comprising forming a control circuitry on the substrate (210).

## Patentansprüche

1. Verfahren zum Ausbilden eines elektrochemischen Sensors, das Verfahren umfassend:
Anordnen einer Isolatorschicht (205A) auf einem Substrat (201);
Ausbilden einer Erfassungselektrode (220) entweder auf der Isolatorschicht (205A) oder auf dem Substrat (201);
Ausbilden einer Gegenelektrode (225) auf der Isolatorschicht (205A), derart dass die Gegenelektrode (225) nicht in Kontakt mit dem Substrat (201) ist;
Anordnen einer dielektrischen Schicht (210) über mindestens einen Teil einer oberen Oberfläche der Isolatorschicht (205A) und auch über einen Teil von jeder von der Erfassungselektrode (220) und der Gegenelektrode (225);
Anordnen einer Photolackschicht auf der dielektrischen Schicht (210) und auch auf der Erfassungselektrode (220) und der Gegenelektrode (225), wobei die Photolackschicht ein Muster umfasst, das dazu konfiguriert ist, mindestens einen Teil der Oberfläche der Erfassungselektrode (220) freizulegen;
Anordnen einer hochoberflächigen Elektrode (223) auf der Erfassungselektrode (220); und
Anordnen eines Elektrolyten (230) auf mindestens einem Teil von jeder von der hochoberflächigen Elektrode (223) und der Gegenelektrode (225),
wobei die hochoberflächige Elektrode (223) eine fraktale Metallelektrode umfasst.

2. Verfahren nach Anspruch 1, wobei die hochoberflächige Elektrode (223) mindestens eines von Gold, Platin, Palladium, Rhodium oder Ruthenium umfasst.

3. Verfahren nach Anspruch 1, wobei das Substrat (201) mindestens eines von einem porösen Siliziumsubstrat, einem porösen Aluminiumoxidsubstrat oder einem Siliziumsubstrat mit Mikrokanälen umfasst.

4. Verfahren nach Anspruch 1, wobei die Erfassungselektrode (220) mindestens eines von Metall oder Metalloxiden wie Kupfer, Gold, Nickel, Platin, Palladium, Rhodium oder Ruthenium umfasst.

5. Verfahren nach Anspruch 1, wobei die dielektrische Schicht (210) mindestens eines von Silizium oder Siliziumnitrid umfasst.

6. Verfahren nach Anspruch 1, wobei die hochoberflächige Elektrode (223) eine poröse Platinelektrode ist.

7. Verfahren nach Anspruch 1, wobei die hochoberflächige Elektrode (223) nicht planare Oberflächen umfasst.

8. Verfahren nach Anspruch 7, wobei die hochoberflächige Elektrode (223) eine Vielzahl von sich nach außen erstreckenden Säulen umfasst.

9. Verfahren nach Anspruch 7, wobei die hochoberflächige Elektrode (223) eine Farnblattstruktur umfasst.

10. Verfahren nach Anspruch 1, wobei der Elektrolyt (230) einen soliden Polymerelektrolyten umfasst.

11. Verfahren nach Anspruch 1, ferner umfassend Durchführen von Vereinzelung des Substrats (201).

12. Verfahren nach Anspruch 1, wobei die Erfassungselektrode (220) und die Gegenelektrode (225) unter Verwendung von thermischer Abscheidung, Zerstäuben, chemischer Dampfabscheidung, Ätzen oder Elektroabscheidung ausgebildet sind.

13. Verfahren nach Anspruch 1, wobei der Elektrolyt (230) unter Verwendung von mindestens einem von Tintenstrahldrucken, Aerosolstrahldrucken oder Siebdrucken abgeschieden wird.

14. Verfahren nach Anspruch 1, ferner umfassend Ausbilden einer Steuerschaltung auf dem Substrat (210).

## Revendications

1. Procédé de formation d'un capteur électrochimique, le procédé comprenant :
le dépôt d'une couche isolante (205A) sur un substrat (201) ;
la formation d'une électrode de détection (220) soit sur la couche isolante (205A) soit sur le substrat (201) ;
la formation d'une contre-électrode (225) sur la couche isolante (205A), de telle sorte que la contre-électrode (225) n'est pas en contact avec le substrat (201) ;
le dépôt d'une couche diélectrique (210) sur au moins une partie d'une surface supérieure de la couche isolante (205A) et également sur une partie de chacune de l'électrode de détection (220) et de la contre-électrode (225) ;
le dépôt d'une couche de résine photosensible sur la couche diélectrique (210) et également sur l'électrode de détection (220) et la contre-électrode (225), dans lequel la couche de résine photosensible comprend un motif configuré pour exposer au moins une partie de la surface de l'électrode de détection (220) ;
le dépôt d'une électrode à grande surface spécifique (223) sur l'électrode de détection (220) ; et
le dépôt d'un électrolyte (230) sur au moins une partie de chacune de l'électrode à grande surface spécifique (223) et de la contre-électrode (225),
dans lequel l'électrode à grande surface spécifique (223) comprend une électrode métallique fractale.

2. Procédé selon la revendication 1, dans lequel l'électrode à grande surface spécifique (223) comprend au moins l'un parmi or, platine, palladium, rhodium ou ruthénium.

3. Procédé selon la revendication 1, dans lequel le substrat (201) comprend au moins l'un d'un substrat de silicium poreux, d'un substrat d'alumine poreuse ou d'un substrat de silicium à micro-canaux.

4. Procédé selon la revendication 1, dans lequel l'électrode de détection (220) comprend au moins l'un parmi métal ou oxydes métalliques tels que cuivre, or, nickel, platine, palladium, rhodium ou ruthénium.

5. Procédé selon la revendication 1, dans lequel la couche diélectrique (210) comprend au moins l'un parmi oxyde de silicium ou nitrure de silicium.

6. Procédé selon la revendication 1, dans lequel l'électrode à grande surface spécifique (223) est une électrode de platine poreux.

7. Procédé selon la revendication 1, dans lequel l'électrode à grande surface spécifique (223) comprend des surfaces non planes.

8. Procédé selon la revendication 7, dans lequel l'électrode à grande surface spécifique (223) comprend une pluralité de piliers s'étendant vers l'extérieur.

9. Procédé selon la revendication 7, dans lequel l'électrode à grande surface spécifique (223) comprend une structure en feuille de fougère.

10. Procédé selon la revendication 1, dans lequel l'électrolyte (230) comprend un électrolyte polymère solide.

11. Procédé selon la revendication 1, comprenant en outre la réalisation de la singularisation du substrat (201).

12. Procédé selon la revendication 1, dans lequel l'électrode de détection (220) et la contre-électrode (225) sont formées en utilisant l'un parmi dépôt thermique, pulvérisation cathodique, dépôt chimique en phase vapeur, gravure ou électrodéposition.

13. Procédé selon la revendication 1, dans lequel l'électrolyte (230) est déposé en utilisant au moins l'une parmi impression par jet d'encre, impression par jet d'aérosol ou sérigraphie.

14. Procédé selon la revendication 1, comprenant en outre la formation d'une circuiterie de commande sur le substrat (210).
